(19) Europäisches Patentamt
European Patent Office
Office européen des brevets

(11) **EP 4 815 068 A1**

(12) **EUROPEAN PATENT APPLICATION**
published in accordance with Art. 153(4) EPC

(43) Date of publication:
**30.09.2026 Bulletin 2026/40**

(21) Application number: **24895816.7**

(22) Date of filing: **26.08.2024**

(51) International Patent Classification (IPC):
***H01M 4/66*** *(2006.01)* ***H01M 10/0525*** *(2010.01)*
***C23C 14/20*** *(2006.01)* ***C23C 14/24*** *(2006.01)*

(52) Cooperative Patent Classification (CPC):
**C23C 14/20; C23C 14/24; H01M 4/04; H01M 4/13; H01M 4/66; H01M 10/0525; H01M 10/054;**
Y02E 60/10

(86) International application number:
**PCT/CN2024/114578**

(87) International publication number:
**WO 2025/112715 (05.06.2025 Gazette 2025/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.11.2023 CN 202311606674**

(71) Applicant: **Contemporary Amperex Technology Co., Limited**
**Ningde, Fujian 352100 (CN)**

(72) Inventors:
- **LIU, Xianghui**
  **Ningde, Fujian 352100 (CN)**
- **LIU, Xin**
  **Ningde, Fujian 352100 (CN)**
- **HUANG, Qisen**
  **Ningde, Fujian 352100 (CN)**
- **LI, Mingling**
  **Ningde, Fujian 352100 (CN)**
- **LI, Cheng**
  **Ningde, Fujian 352100 (CN)**
- **CAI, Qiguo**
  **Ningde, Fujian 352100 (CN)**

(74) Representative: **Gong, Jinping**
**CocreateIP**
**Neumarkter Straße 21**
**81673 München (DE)**

(54) **COMPOSITE CURRENT COLLECTOR AND PREPARATION METHOD THEREFOR, AND ELECTRODE SHEET, BATTERY AND ELECTRIC APPARATUS**

(57) A composite current collector and a preparation method therefor, and an electrode sheet, a battery and an electric apparatus. The composite current collector comprises a support layer, and a bonding layer, a first conductive layer and a second conductive layer, which are sequentially arranged in a stacked manner on at least one surface of the support layer, wherein the first conductive layer contains a first metal material, the second conductive layer contains a second metal material, and the grain size of the second metal material is smaller than that of the first metal material. Thus, the fracture strength and tensile modulus of the composite current collector are effectively improved, and the problems of wrinkling and shrinkage in a tab area of the composite current collector are ameliorated.

7
74
73
72
71
FIG. 1

## Description

## CROSS-REFERENCE TO RELATED APPLICATIONS

The present application claims priority to Chinese Patent Application No. 202311606674.1, filed with the China National Intellectual Property Administration on November 27, 2023 and entitled "COMPOSITE CURRENT COLLECTOR AND PREPARATION METHOD THEREOF, ELECTRODE PLATE, BATTERY, AND POWER CONSUMING APPARATUS", which is incorporated herein by reference in its entirety.

## TECHNICAL FIELD

The present application relates to the field of battery technologies, and in particular, to a composite current collector and a preparation method thereof, an electrode plate, a battery, and a power consuming apparatus.

## BACKGROUND

The statement herein merely provides background information related to the present application and does not necessarily constitute the prior art.

Secondary batteries are widely used in a plurality of fields, for example, energy storage power supply systems such as water power stations, thermal power stations, wind power stations, and solar power stations, electric vehicles, and consumer electronic products, due to advantages such as a high energy density, a high output power, a long cycle life, and small environmental pollution. In comparison with a conventional current collector of a pure metal foil material, a composite current collector with a polymer layer in the middle and conductive layers on two sides can reduce an entire weight of the current collector, thereby improving an energy density of a secondary battery. A binding layer is disposed between a support layer and the conductive layer, so that an extension rate and a binding force of the conventional composite current collector can be improved. However, a fracture strength and a tensile modulus of the entire composite current collector are low, and problems of wrinkling and shrinking exist in a tab region.

## SUMMARY

The present application provides a composite current collector and a preparation method thereof, an electrode plate, a battery, and a power consuming apparatus, to improve a fracture strength and a tensile modulus of the composite current collector, and alleviate problems of wrinkling and shrinking in a tab region of the composite current collector.

According to a first aspect of the present application, a composite current collector is provided, including a support layer, and a binding layer, a first conductive layer, and a second conductive layer that are sequentially laminated on at least one surface of the support layer. The first conductive layer includes a first metal material, the second conductive layer includes a second metal material, and a grain size of the second metal material is smaller than a grain size of the first metal material.

In the foregoing composite current collector, the grain size of the second metal material is smaller than the grain size of the first metal material, so that the second conductive layer has more grain boundaries than the first conductive layer, thereby greatly improving a fracture strength and a tensile modulus of the composite current collector. In addition, an increase in a quantity of grain boundaries of the second conductive layer can improve a heat conduction effect of the composite current collector. Therefore, problems of wrinkling and shrinking caused by drying stress when a tab region of the composite current collector is coated can be alleviated, thereby improving reliability of welding a tab, and reducing a direct current internal resistance of a battery.

In some implementations, a ratio of the grain size of the first metal material to the grain size of the second metal material ranges from 2 to 50, and optionally, ranges from 2.5 to 40.

In some implementations, a difference between the grain size of the first metal material and the grain size of the second metal material ranges from 200 nm to 3300 nm, and optionally, ranges from 300 nm to 3100 nm.

In some implementations, the grain size of the second metal material ranges from 50 nm to 300 nm.

In some implementations, the grain size of the first metal material ranges from 500 nm to 3000 nm.

In some implementations, the first metal material and the second metal material each independently include one or more of aluminum and an aluminum alloy.

In some implementations, a ratio of a thickness of the first conductive layer to a thickness of the second conductive layer ranges from 1 to 10, and optionally, ranges from 1.5 to 8.

In some implementations, the thickness of the first conductive layer ranges from 500 nm to 1500 nm, and optionally, ranges from 600 nm to 1200 nm.

In some implementations, the thickness of the second conductive layer ranges from 100 nm to 700 nm, and

optionally, ranges from 200 nm to 500 nm.

In some implementations, a compactness of the composite current collector ≥ 90%.

In some implementations, a compactness of the first conductive layer ≥ 60%.

In some implementations, a tensile modulus of the composite current collector ranges from 5 GPa to 12 GPa.

In some implementations, a fracture strength of the composite current collector ≥ 160 MPa.

In some implementations, the composite current collector further includes a passivation layer, and the passivation layer is disposed between the binding layer and the first conductive layer.

In some implementations, a thickness of the passivation layer ranges from 10 nm to 200 nm.

In some implementations, the passivation layer includes a passivator, and the passivator includes one or more of an organic phosphate, a chromate, a dichromate, Al2O3, SiO2, and Si3N4.

In some implementations, the organic phosphate includes one or more of etidronic acid, diethylenetriaminepenta(methylenephosphonic) acid, triethylenetetramine hexamethylphosphonic acid, and ethylenediamine tetramethylenephosphonic acid.

In some implementations, the chromate includes one or more of sodium chromate, potassium chromate, magnesium chromate, and silver chromate.

In some implementations, the dichromate includes one or more of ammonium dichromate, potassium dichromate, sodium dichromate, and magnesium dichromate.

In some implementations, a thickness of the binding layer ranges from 300 nm to 700 nm.

In some implementations, the binding layer includes a binder. The binder includes one or more of a binding composition, polyurethane, epoxy resin, polyacrylate, polyvinyl acetate, unsaturated polyester, phenolic resin, urea-formaldehyde resin, polyolefin resin, organic silicone resin, an ethylene-acrylic acid copolymer, an ethylene-vinyl acetate copolymer, an ethylene-vinyl alcohol copolymer, acrylic resin, polycarbonate, and polyamide. The binding composition includes isocyanate and polyester polyol.

In some implementations, the polyurethane includes one or more of thermoplastic polyurethane and reactive polyurethane.

In some implementations, a thickness of the support layer ranges from 2 μm to 10 μm.

In some implementations, the support layer includes one or more of a polymer material and a polymer matrix composite material.

In some implementations, the polymer material includes one or more of polyamide, polyimide, polyethylene terephthalate, polybutylene terephthalate, polyethylene naphthalate, polycarbonate, polyethylene, polypropylene, poly(propylene-co-ethylene), a acrylonitrile-butadiene-styrene copolymer, polyvinyl alcohol, polystyrene, polyvinyl chloride, polyvinylidene fluoride, polytetrafluoroethylene, poly(sodium-p-styrenesulfonate), polyacetylene, silicone rubber, polyoxymethylene, polyphenylene oxide, polyphenylene sulfide, polyethylene glycol, a polythiazyl polymer material, polyphenyl, polypyrrole, polyaniline, polythiophene, polypyridine, cellulose, starch, protein, epoxy resin, phenolic resin, a derivative thereof, a crosslinked polymer thereof, or a copolymer thereof.

In some implementations, the polymer matrix composite material includes the polymer material and an additive, and the additive includes one or more of a third metal material and an inorganic non-metal material.

In some implementations, the third metal material includes one or more of aluminum, copper, nickel, iron, silver, titanium, and alloys thereof.

In some implementations, the inorganic non-metal material includes one or more of graphite, conductive carbon, aluminum oxide, silicon oxide, silicon carbide, and silicon dioxide.

According to a second aspect of the present application, a preparation method of a composite current collector is provided. The method includes the following step:

forming, on at least one surface of a support layer, a binding layer, a first conductive layer, and a second conductive layer that are sequentially laminated, where the first conductive layer includes a first metal material, the second conductive layer includes a second metal material, and a grain size of the second metal material is smaller than a grain size of the first metal material.

The foregoing preparation method is simple, and is suitable for large-scale manufacturing of the composite current collector.

In some implementations, the step of forming a second conductive layer includes: disposing the second conductive layer on a surface of the first conductive layer by using a vapor deposition method and/or a magnetron sputtering method.

In some implementations, the step of forming, on at least one surface of a support layer, a binding layer and a first conductive layer that are sequentially laminated includes: disposing a first slurry including a binder on a surface of at least one of the support layer and the first conductive layer, to solidify the first slurry and form the binding layer.

In some implementations, the preparation method of the composite current collector further includes: a step of forming a passivation layer between the binding layer and the first conductive layer.

In some implementations, the step of forming a passivation layer includes: disposing a second slurry including a

passivator on one surface of the first conductive layer, to solidify the second slurry and form the passivation layer.

According to a third aspect of the present application, an electrode plate is provided, including at least one of the composite current collector in the first aspect of the present application and a composite current collector prepared by using the preparation method in the second aspect of the present application.

The electrode plate in the present application includes at least one of the composite current collector provided in the present application and the composite current collector prepared by using the preparation method provided in the present application, and therefore has at least advantages the same as those of the composite current collector or the composite current collector prepared by using the preparation method.

According to a fourth aspect of the present application, a battery is provided, including at least one of the composite current collector in the first aspect of the present application, a composite current collector prepared by using the preparation method in the second aspect of the present application, and the electrode plate in the third aspect of the present application.

The battery in the present application includes at least one of the composite current collector provided in the present application, the composite current collector prepared by using the preparation method provided in the present application, and the electrode plate provided in the present application, and therefore has at least advantages the same as those of the composite current collector, the composite current collector prepared by using the preparation method, or the electrode plate.

According to a fifth aspect of the present application, a power consuming apparatus is provided, including the battery in the fourth aspect of the present application.

The power consuming apparatus in the present application includes the battery provided in the present application, and therefore has at least advantages the same as those of the battery.

Details of one or more embodiments of the present application are provided in the accompanying drawings and descriptions below. Other features, objects, and advantages of the present application will become apparent from the specification, the accompanying drawings, and the claims.

## BRIEF DESCRIPTION OF THE DRAWINGS

To better describe and illustrate embodiments or examples provided in the present application, refer to one or more accompanying drawings. However, additional details or examples used to describe the accompanying drawings should not be regarded as limitations to the scopes of any one of the applications disclosed, the embodiments or examples described for the present, and the most modes of the embodiments understood for the present. In addition, in all the accompanying drawings, same parts are indicated by using same reference numerals. In the accompanying drawings:

FIG. 1 is a schematic diagram of a composite current collector according to an implementation of the present application;

FIG. 2 is a schematic diagram of a composite current collector according to another implementation of the present application;

FIG. 3 is a schematic diagram of a battery cell according to an implementation of the present application;

FIG. 4 is an exploded view of the battery cell shown in FIG. 3 according to an implementation of the present application;

FIG. 5 is a schematic diagram of a battery module according to an implementation of the present application;

FIG. 6 is a schematic diagram of a battery pack according to an implementation of the present application;

FIG. 7 is an exploded view of the battery pack shown in FIG. 6 according to an implementation of the present application; and

FIG. 8 is a schematic diagram of a power consuming apparatus using a secondary battery as a power supply according to an implementation of the present application.

Descriptions of reference numerals:

1. battery pack; 2. upper box body; 3. lower box body; 4. battery module; 5. battery cell; 51. housing; 52. electrode assembly; 53. cover plate; 6. power consuming apparatus; 7. composite current collector; 71. support layer; 72. binding layer; 73. first conductive layer; 74. second conductive layer; and 75. passivation layer.

## DETAILED DESCRIPTION

Hereinafter, some implementations of a composite current collector and a preparation method thereof, an electrode plate, a battery, and a power consuming apparatus of the present application are described in detail with reference to the accompanying drawings as appropriate. However, there may be situations in which unnecessary detailed descriptions are omitted. For example, there are situations in which detailed descriptions of well-known matters are omitted and repeated descriptions of a same structure are actually provided. Thus, the following descriptions do not

become unnecessarily lengthy, which facilitates the easy comprehension of those skilled in the art. In addition, the accompanying drawings and the following descriptions are provided for those skilled in the art to fully understand the present application and are not intended to limit the subject matter recorded in the claims.

A "range" disclosed in the present application may be limited in a form of a lower limit and an upper limit. The given range is limited by selecting a lower limit and an upper limit, and the selected lower limit and upper limit define boundaries of a particular range. A range defined in this manner may be inclusive or exclusive of the end values, and any end value may be independently inclusive or exclusive and may be arbitrarily combined, that is, any lower limit may be combined with any upper limit to form a range. For example, if ranges of 60-120 and 80-110 are listed for a particular parameter, it is to be understood that ranges of 60-110 and 80-120 are also expected. In addition, if the minimum range values 1 and 2 are listed, and if the maximum range values 3, 4, and 5 are listed, the following ranges can all be expected: 1-3, 1-4, 1-5, 2-3, 2-4, and 2-5. In the present application, unless otherwise specified, the numerical range "a to b" represents an abbreviated representation of any combination of real numbers between a and b, where a and b are both real numbers. For example, the numerical range "0-5" means that all real numbers between 0-5 are listed herein, and "0-5" is merely an abbreviated representation of the combination of these numbers. In addition, when a parameter is expressed as an integer $\geq 2$, it is equivalent to disclosing that the parameter is, for example, an integer of 2, 3, 4, 5, 6, 7, 8, 9, 10, 11, 12, or the like. For example, when a parameter is expressed as an integer selected from "2-10", it is equivalent to lists integers 2, 3, 4, 5, 6, 7, 8, 9, and 10.

The terms "plurality", "multiple", and the like in the present application mean greater than or equal to 2 in number, unless otherwise limited. For example, "one or more" means one or more than or equal to two.

If there is no special explanation, all implementation methods and optional implementation methods of the present application can be combined to form new technical solutions.

Reference in this specification to "an embodiment" means that a specified feature, structure, or characteristic described with reference to the embodiment may be included in at least one embodiment or implementation of the present application. Appearances of the phrase in various locations in this specification are not necessarily all referring to a same embodiment, nor are separate or alternative embodiments mutually exclusive of another embodiment. It is explicitly and implicitly understood by a person skilled in the art that embodiments described in this specification may be combined with another embodiment. An "implementation" mentioned in this specification has a similar understanding.

A person skilled in the art may understand that, in the method of each implementation or embodiment, a writing sequence of steps does not mean a strict execution sequence that constitutes any limitation on an implementation process, and a detailed execution sequence of the steps should be determined based on functions and possible internal logics thereof. Unless otherwise specified, all the steps of the present application may be performed sequentially or randomly, and in some embodiments, sequentially. For example, the method including steps (a) and (b) indicates that the method may include steps (a) and (b) performed sequentially, or the method may include steps (b) and (a) performed sequentially. For example, reference to "the method may further include step (c)" indicates that step (c) may be added to the method in any order, e.g., the method may include steps (a), (b) and (c), or steps (a), (c) and (b), or steps (c), (a) and (b), etc.

In the present application, unless otherwise specified, an open technical feature or technical solution described by using words such as "contain", "comprise", and "include" does not exclude additional members other than listed members, and may be considered as providing a closed feature or solution including the listed members, and further providing an open feature or solution including the additional members other than the listed members. For example, A includes a1, a2, and a3. Unless otherwise specified, A may further include other members, or may not include additional members. It may be considered that a feature or solution "A includes a1, a2, and a3" is provided, and a feature or solution "A not only includes a1, a2, and a3, but also includes other members" is further provided. In the present application, unless otherwise specified, A (such as B) indicates that B is a non-limiting example of A. It can be understood that A is not limited to B.

In the present application, "optionally", "optional", and "optional" refer to having or not having, that is, selected from any one of two parallel solutions: "having" or "not having". If there are a plurality of "optional" in one technical solution, unless otherwise specified and there are no contradictions or mutual constraints, each "optional" is independent.

A material of a support layer of a conventional composite current collector mainly includes PET (polyethylene terephthalate) or PP (polypropylene). Although a binding layer disposed between the support layer and a conductive layer can improve an extension rate and a binding force of the conventional composite current collector, a fracture strength and a tensile modulus of the entire composite current collector are low. In addition, during coating, a tab region is very easily wrinkled and shrunken due to an effect of drying stress, and consequently, welding of a tab and a direct current internal resistance (DCR) of a battery are affected.

In view of this, the present application provides a composite current collector, including a support layer, and a binding layer, a first conductive layer, and a second conductive layer that are sequentially laminated on at least one surface of the support layer. The first conductive layer includes a first metal material, the second conductive layer includes a second metal material, and a grain size of the second metal material is smaller than a grain size of the first metal material.

The grain size of the second metal material is smaller than the grain size of the first metal material, so that the second conductive layer has more grain boundaries than the first conductive layer, thereby greatly improving a fracture strength and a tensile modulus of the composite current collector. In addition, an increase in a quantity of grain boundaries of the second conductive layer can improve a heat conduction effect of the composite current collector. Therefore, problems of wrinkling and shrinking caused by drying stress when a tab region of the composite current collector is coated can be alleviated, thereby improving reliability of welding a tab, and reducing a direct current internal resistance (DCR) of a battery.

An implementation of the present application provides a composite current collector, including a support layer, and a binding layer, a first conductive layer, and a second conductive layer that are sequentially laminated on at least one surface of the support layer. The first conductive layer includes a first metal material, the second conductive layer includes a second metal material, and a grain size of the second metal material is smaller than a grain size of the first metal material.

In the foregoing composite current collector, the grain size of the second metal material is smaller than the grain size of the first metal material, so that the second conductive layer has more grain boundaries than the first conductive layer, thereby greatly improving a fracture strength and a tensile modulus of the composite current collector. In addition, an increase in a quantity of grain boundaries of the second conductive layer can improve a heat conduction effect of the composite current collector. Therefore, problems of wrinkling and shrinking caused by drying stress when a tab region of the composite current collector is coated can be alleviated, thereby improving reliability of welding a tab, and reducing a direct current internal resistance (DCR) of a battery.

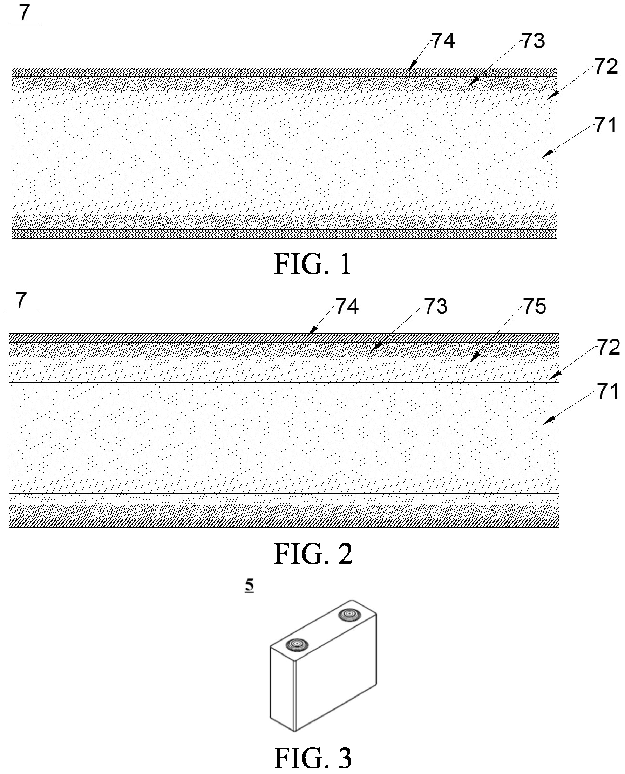

In some implementations, with reference to FIG. 1, a composite current collector 7 includes a support layer 71, a binding layer 72, a first conductive layer 73, and a second conductive layer 74. The binding layer 72, the first conductive layer 73, and the second conductive layer 74 are sequentially laminated on two opposite surfaces of the support layer 71 along a direction away from the support layer 71. The first conductive layer 73 includes a first metal material, the second conductive layer 74 includes a second metal material, and a grain size of the second metal material is smaller than a grain size of the first metal material.

In some implementations, a ratio of the grain size of the first metal material to the grain size of the second metal material ranges from 2 to 50. In this way, the fracture strength and the tensile modulus of the composite current collector can be further improved, and the problems of wrinkling and shrinking caused by the drying stress when the tab region of the composite current collector is coated can be further alleviated. In some embodiments, the ratio of the grain size of the first metal material to the grain size of the second metal material ranges from 2.5 to 40.

In some implementations, a difference between the grain size of the first metal material and the grain size of the second metal material ranges from 200 nm to 3300 nm. In this way, the fracture strength and the tensile modulus of the composite current collector can be further improved, and the problems of wrinkling and shrinking caused by the drying stress when the tab region of the composite current collector is coated can be further alleviated. In some embodiments, the difference between the grain size of the first metal material and the grain size of the second metal material ranges from 300 nm to 3100 nm.

In the present application, the unit "nm" refers to a nanometer.

In some implementations, the grain size of the second metal material ranges from 50 nm to 300 nm. When the grain size of the second metal material is within the foregoing range, the second conductive layer has more grain boundaries. Therefore, the fracture strength and the tensile modulus of the composite current collector can be further improved, and the problems of wrinkling and shrinking caused by the drying stress when the tab region of the composite current collector is coated are further alleviated. It may be understood that the grain size of the second metal material includes, but is not limited to, 50 nm, 100 nm, 150 nm, 200 nm, 250 nm, and 300 nm.

In some implementations, the grain size of the first metal material ranges from 500 nm to 3000 nm. When the grain size of the first metal material is within the foregoing range, the fracture strength and the tensile modulus of the composite current collector can be further improved, and the problems of wrinkling and shrinking caused by the drying stress when the tab region of the composite current collector is coated are further alleviated. It may be understood that the grain size of the first metal material includes, but is not limited to, 500 nm, 1000 nm, 1500 nm, 2000 nm, 2500 nm, and 3000 nm.

In some implementations, the first metal material and the second metal material each independently include one or more of aluminum and an aluminum alloy.

In some implementations, a ratio of a thickness of the first conductive layer to a thickness of the second conductive layer ranges from 1 to 10. Therefore, when the fracture strength and the tensile modulus of the composite current collector are improved, no new hole defect is additionally added, fluctuation of the thickness of the first conductive layer and the thickness of the second conductive layer is small, characteristics of a large binding force and high extension of the composite current collector are maintained, a battery preparation requirement is satisfied, a risk that the first conductive layer and the second conductive layer crack is reduced, and the DCR of the battery is maintained within a proper range. In some embodiments, the ratio of the thickness of the first conductive layer to the thickness of the second conductive layer ranges from 1.5 to 8.

In some implementations, the thickness of the first conductive layer ranges from 500 nm to 1500 nm. Therefore,

when the fracture strength and the tensile modulus of the composite current collector are improved, no new hole defect is additionally added, fluctuation of the thickness of the first conductive layer is small, the characteristics of the large binding force and the high extension of the composite current collector are maintained, the battery preparation requirement is satisfied, a risk that the first conductive layer cracks is reduced, and the DCR of the battery is maintained within the proper range. It may be understood that the thickness of the first conductive layer includes, but is not limited to, 500 nm, 600 nm, 700 nm, 800 nm, 900 nm, 1000 nm, 1100 nm, 1200 nm, 1300 nm, 1400 nm, and 1500 nm. In some embodiments, the thickness of the first conductive layer ranges from 600 nm to 1200 nm.

In some implementations, the thickness of the second conductive layer ranges from 100 nm to 700 nm. Therefore, when the fracture strength and the tensile modulus of the composite current collector are improved, no new hole defect is additionally added, fluctuation of the thickness of the second conductive layer is small, the characteristics of the large binding force and the high extension of the composite current collector are maintained, the battery preparation requirement is satisfied, a risk that the second conductive layer cracks is reduced, and the DCR of the battery is maintained within the proper range. It may be understood that the thickness of the second conductive layer includes, but is not limited to, 100 nm, 200 nm, 300 nm, 400 nm, 500 nm, 600 nm, and 700 nm. In some embodiments, the thickness of the second conductive layer ranges from 200 nm to 500 nm.

In some implementations, a compactness of the composite current collector ≥ 90%. When the compactness of the composite current collector is within the foregoing range, it is beneficial to further improve the fracture strength and the tensile modulus of the composite current collector.

In the present application, the compactness means uniformity of the conductive layer, and also represents a compactness degree. Generally, when the compactness of the composite current collector is poor, light leakage occurs in a dark field situation of a backlight screen, and the excessively poor compactness affects mechanical strength performance of the composite current collector. The conductive layer refers to at least one of the first conductive layer and the second conductive layer.

In some implementations, a compactness of the first conductive layer ≥ 60%. Therefore, it is beneficial to further improve the fracture strength and the tensile modulus of the composite current collector.

In some implementations, the tensile modulus of the composite current collector ranges from 5 GPa to 12 GPa. It may be understood that the tensile modulus of the composite current collector includes, but is not limited to, 5 GPa, 6 GPa, 7 GPa, 8 GPa, 9 GPa, 10 GPa, 11 GPa, and 12 GPa.

In the present application, the unit "GPa" refers to a gigapascal.

In some implementations, the fracture strength of the composite current collector ≥ 160 megapascals (MPa).

In some implementations, the composite current collector further includes a passivation layer, and the passivation layer is disposed between the binding layer and the first conductive layer. In this way, the first conductive layer can be prevented from being corroded by an electrolyte solution, thereby improving peel strength between the support layer and the first conductive layer.

In some implementations, with reference to FIG. 2, the composite current collector 7 further includes a passivation layer 75, and the passivation layer 75 is disposed between the binding layer 72 and the first conductive layer 73. In other words, the composite current collector 7 includes the support layer 71, and the binding layer 72, the passivation layer 75, the first conductive layer 73, and the second conductive layer 74 that are sequentially laminated on at least one surface of the support layer 71 In this way, the first conductive layer 73 can be prevented from being corroded by an electrolyte solution, thereby improving peel strength between the support layer 71 and the first conductive layer 73.

In some implementations, the composite current collector includes the support layer, the binding layer, the passivation layer, the first conductive layer, and the second conductive layer. The binding layer, the passivation layer, the first conductive layer, and the second conductive layer are sequentially laminated on the two opposite surfaces of the support layer along the direction away from the support layer.

In some implementations, a thickness of the passivation layer ranges from 10 nm to 200 nm. It may be understood that the thickness of the passivation layer includes, but is not limited to, 10 nm, 30 nm, 50 nm, 80 nm, 100 nm, 120 nm, 150 nm, 180 nm, and 200 nm.

In some implementations, the passivation layer includes a passivator, and the passivator includes one or more of an organic phosphate, a chromate, a dichromate, $Al_2O_3$, $SiO_2$, and $Si_3N_4$. In this way, the first conductive layer can be further prevented from being corroded by an electrolyte solution, thereby further improving the peel strength between the support layer and the first conductive layer. In some embodiments, the organic phosphate includes one or more of etidronic acid, diethylenetriaminepenta(methylenephosphonic) acid, triethylenetetramine hexamethylphosphonic acid, and ethylenediamine tetramethylenephosphonic acid. In some embodiments, the chromate includes one or more of sodium chromate, potassium chromate, magnesium chromate, and silver chromate. In some embodiments, the dichromate includes one or more of ammonium dichromate, potassium dichromate, sodium dichromate, and magnesium dichromate.

In some implementations, a thickness of the binding layer ranges from 300 nm to 700 nm. It may be understood that the thickness of the binding layer includes, but is not limited to, 300 nm, 400 nm, 500 nm, 600 nm, and 700 nm.

In some implementations, the binding layer includes a binder. The binder includes one or more of a binding

composition, polyurethane, epoxy resin, polyacrylate, polyvinyl acetate, unsaturated polyester, phenolic resin, urea-formaldehyde resin, polyolefin resin, organic silicone resin, an ethylene-acrylic acid copolymer, an ethylene-vinyl acetate copolymer, an ethylene-vinyl alcohol copolymer, acrylic resin, polycarbonate, and polyamide. The binding composition includes isocyanate and polyester polyol. In some embodiments, the polyurethane includes one or more of thermoplastic polyurethane and reactive polyurethane.

In some implementations, a thickness of the support layer ranges from 2 μm to 10 μm. It may be understood that the thickness of the support layer includes, but is not limited to, 2 μm, 3 μm, 4 μm, 5 μm, 6 μm, 7 μm, 8 μm, 9 μm, and 10 μm.

In the present application, the unit "μm" refers to a micrometer.

In some implementations, the support layer includes one or more of a polymer material and a polymer matrix composite material.

In some implementations, the polymer material includes one or more of polyamide, polyimide, polyethylene terephthalate, polybutylene terephthalate, polyethylene naphthalate, polycarbonate, polyethylene, polypropylene, poly(propylene-co-ethylene), a acrylonitrile-butadiene-styrene copolymer, polyvinyl alcohol, polystyrene, polyvinyl chloride, polyvinylidene fluoride, polytetrafluoroethylene, poly(sodium-p-styrenesulfonate), polyacetylene, silicone rubber, polyoxymethylene, polyphenylene oxide, polyphenylene sulfide, polyethylene glycol, a polythiazyl polymer material, polyphenyl, polypyrrole, polyaniline, polythiophene, polypyridine, cellulose, starch, protein, epoxy resin, phenolic resin, a derivative thereof, a crosslinked polymer thereof, or a copolymer thereof.

In some implementations, the polymer matrix composite material includes the polymer material and an additive, and the additive includes one or more of a third metal material and an inorganic non-metal material. In some embodiments, the third metal material includes one or more of aluminum, copper, nickel, iron, silver, titanium, and alloys thereof. In some embodiments, the inorganic non-metal material includes one or more of graphite, conductive carbon, aluminum oxide, silicon oxide, silicon carbide, and silicon dioxide.

Another implementation of the present application provides a preparation method of the foregoing composite current collector. The method includes the following step:

forming, on at least one surface of a support layer, a binding layer, a first conductive layer, and a second conductive layer that are sequentially laminated.

The foregoing preparation method is simple, and is suitable for large-scale manufacturing of the composite current collector. It may be understood that the binding layer is configured to connect the support layer to the first conductive layer.

In some implementations, the step of forming a second conductive layer includes: disposing the second conductive layer on a surface of the first conductive layer by using a vapor deposition method and/or a magnetron sputtering method.

In some implementations, the step of forming a first conductive layer includes: thinning a conductive layer including a first metal material, to form the first conductive layer. A thickness of the conductive layer may be reduced to an appropriate thickness through at least one of physical etching and chemical etching (chemical corrosion), to form the first conductive layer.

In some implementations, the step of forming, on at least one surface of a support layer, a binding layer and a first conductive layer that are sequentially laminated includes: disposing a first slurry including a binder on a surface of at least one of the support layer and the first conductive layer, to solidify the first slurry and form the binding layer. It may be understood that the first slurry including the binder may be disposed on the surface of the support layer or the surface of the first conductive layer, or may be disposed on both the surface of the support layer and the surface of the first conductive layer.

In some implementations, the preparation method of the composite current collector further includes: a step of forming a passivation layer between the binding layer and the first conductive layer. The disposed passivation layer can prevent the first conductive layer from being corroded by an electrolyte solution, thereby improving peel strength between the support layer and the first conductive layer.

In some implementations, the step of forming a passivation layer includes: disposing a second slurry including a passivator on one surface of the first conductive layer, to solidify the second slurry and form the passivation layer.

In some implementations, the step of forming, on at least one surface of a support layer, a binding layer and a passivation layer that are sequentially laminated includes: disposing a first slurry including a binder on a surface of at least one of the support layer and the passivation layer, to solidify the first slurry and form the binding layer.

Still another implementation of the present application provides an electrode plate, including the foregoing composite current collector. The electrode plate includes the foregoing composite current collector, and therefore, the electrode plate has at least advantages the same as those of the composite current collector. In some embodiments, the electrode plate may be at least one of a positive electrode plate and a negative electrode plate.

Still another implementation of the present application further provides a battery, including the foregoing composite current collector or the foregoing electrode plate. The battery includes the foregoing composite current

collector or the foregoing electrode plate, and therefore, the battery has at least advantages the same as those of the composite current collector or the electrode plate. The battery includes a secondary battery and a primary battery. The secondary battery includes, but is not limited to, at least one of a lithium-ion battery, a sodium-ion battery, and a magnesium-ion battery. The primary battery includes, but is not limited to, a lithium primary battery.

Still another implementation of the present application further provides a power consuming apparatus, including the foregoing battery. The power consuming apparatus includes the foregoing battery, and therefore, the power consuming apparatus has at least advantages the same as those of the battery.

In addition, the battery and the power consuming apparatus of the present application are described below with appropriate reference to the accompanying drawings.

Generally, a secondary battery includes a positive electrode plate, a negative electrode plate, an electrolyte, and a separator. During charge/discharge of a battery, active ions are intercalated and de-intercalated back and forth between the positive electrode plate and the negative electrode plate. The electrolyte is configured to conduct the ions between the positive electrode plate and the negative electrode plate. The separator is disposed between the positive electrode plate and the negative electrode plate, and is mainly configured to prevent a short circuit between a positive electrode and a negative electrode and enable the ions to pass through.

Positive electrode plate

The positive electrode plate includes a positive electrode current collector and a positive electrode active material layer arranged on at least one surface of the positive electrode current collector, and the positive electrode active material layer includes a positive electrode active material.

In a non-limiting example, the positive electrode current collector has two surfaces opposite to each other in a thickness direction of the positive electrode current collector, and the positive electrode active material layer is arranged on either or both of the two opposite surfaces of the positive electrode current collector.

In some embodiments, the positive electrode current collector may use the foregoing composite current collector of the present application.

In some embodiments, the positive electrode current collector may use a metal foil or another composite current collector. For example, as the metal foil, an aluminum foil may be used. The another composite current collector may include a polymer material substrate and a metal layer formed on at least one surface of the polymer material substrate. The another composite current collector may be formed by forming a metal material on the polymer material substrate. In the positive electrode current collector, non-limiting examples of the metal material may include one or more of aluminum, an aluminum alloy, nickel, a nickel alloy, titanium, a titanium alloy, silver, a silver alloy, and the like. In the positive electrode current collector, non-limiting examples of the polymer material substrate may include one or more of polypropylene (PP), polyethylene terephthalate (PET), polybutylene terephthalate (PBT), polystyrene (PS), polyethylene (PE), and other substrates.

It may be understood that, during charge/discharge of the battery, lithium (Li) is de-intercalated and consumed, and a content of Li in the positive electrode plate differs when the battery is discharged to different states. In examples of the positive electrode active material in the present application, unless otherwise specified, the content of Li is in an initial state of the material. When the positive electrode active material is used in the positive electrode plate in a battery system, after a charge/discharge cycle, the content of Li in the positive electrode active material included in the electrode plate usually changes. The content of Li may be measured by using a molar content, but the present application is not limited thereto. For " the content of Li is in an initial state of the material", the initial state of the material refers to a state before the material is fed to a positive electrode slurry. It may be understood that a new material obtained by performing proper modification based on the listed positive electrode active material also falls within a scope of the positive electrode active material. The proper modification refers to a modification manner acceptable for the positive electrode active material, and is coating modification in a non-limiting example.

In examples of the positive electrode active material in the present application, a content of oxygen (O) is merely a theoretical state value. Oxygen released by a lattice causes a change in a molar content of oxygen, and the actual content of O fluctuates. The content of O may be measured by using a molar content, but the present application is not limited thereto.

In some implementations, the positive electrode active material may be a positive electrode active material known in the art for a battery. In a non-limiting example, the positive electrode active material may include one or more of the following materials: a lithium-containing phosphate of an olivine structure, a lithium transition metal oxide, and respective modified compounds thereof. However, the present application is not limited to such materials, and another conventional material that can be used as the positive electrode active material for the battery may alternatively be used. These positive electrode active materials can be used alone or in combination with two or more. Examples of the lithium transition metal oxide may include, but are not limited to, one or more of a lithium cobalt oxide (such as $LiCoO_2$), a lithium nickel oxide, a lithium manganese oxide, a lithium nickel cobalt oxide, a lithium manganese cobalt oxide, a lithium nickel

manganese oxide, a lithium nickel cobalt manganese oxide, a lithium nickel cobalt aluminum oxide, and modified compounds thereof. Non-limiting examples of the lithium-containing phosphate of the olivine structure may include, but are not limited to, one or more of a lithium iron phosphate, a composite material of a lithium iron phosphate and carbon, a lithium manganese phosphate, a composite material of a lithium manganese phosphate and carbon, a lithium manganese iron phosphate, and a composite material of a lithium manganese iron phosphate and carbon. A non-limiting example of the lithium cobalt oxide may include $LiCoO_2$. A non-limiting example of the lithium nickel oxide may include $LiNiO_2$. A non-limiting example of the lithium manganese oxide may include $LiMnO_2$, $LiMn_2O_4$, or the like. A non-limiting example of the lithium nickel cobalt manganese oxide may include $LiNi_{1/3}Co_{1/3}Mn_{1/3}O_2$ (which may also be referred to as $NCM_{333}$), $LiNi_{0.5}Co_{0.2}Mn_{0.3}O_2$ (which may also be referred to as $NCM_{523}$), $LiNi_{0.5}Co_{0.25}Mn_{0.25}O_2$ (which may also be referred to as $NCM_{211}$), $LiNi_{0.6}Co_{0.2}Mn_{0.2}O_2$ (which may also be referred to as $NCM_{622}$), $LiNi_{0.8}Co_{0.1}Mn_{0.1}O_2$ (which may also be referred to as $NCM_{811}$), or the like. A non-limiting example of the lithium nickel cobalt aluminum oxide may include $LiNi_{0.8}Co_{0.15}Al_{0.05}O_2$.

The positive electrode active material includes a sodium-ion active material.

In an example, the sodium-ion active material may include one or more of the following materials: one or more of a sodium transition metal oxide, a polyanionic compound, and a Prussian blue compound. However, the present application is not limited to such materials, and another conventional known material that can be used as the positive electrode active material for the sodium-ion battery may alternatively be used.

In an optional technical solution of the present application, in the sodium transition metal oxide, transition metal may include one or more of Mn, Fe, Ni, Co, Cr, Cu, Ti, Zn, V, Zr, and Ce. A non-limiting example of the sodium transition metal oxide may be $Na_xMO_2$. M may include one or more of Ti, V, Mn, Co, Ni, Fe, Cr, and Cu, and $0 < x \leq 1$.

In an optional technical solution of the present application, the polyanionic compound may be a type of compounds including sodium ions, transition metal ions, and tetrahedral $(YO_4)^{n-}$ anionic units. The transition metal may include one or more of Mn, Fe, Ni, Co, Cr, Cu, Ti, Zn, V, Zr, and Ce. Y may be one or more of P, S, and Si. n represents a valence state of $(YO_4)^{n-}$.

The polyanionic compound may alternatively be a type of compounds including sodium ions, transition metal ions, tetrahedral $(YO_4)^{n-}$ anionic units, and halogen anions. The transition metal may include one or more of Mn, Fe, Ni, Co, Cr, Cu, Ti, Zn, V, Zr, and Ce. Y may be one or more of P, S, and Si. n represents a valence state of $(YO_4)^{n-}$. The halogen may be one or more of F, Cl, and Br.

The polyanionic compound may alternatively be a type of compounds including sodium ions, tetrahedral $(YO_4)^{n-}$ anionic units, polyhedral units $(ZO_y)^{m+}$, and optional halogen anions. Y may be one or more of P, S, and Si. n represents a valence state of $(YO_4)^{n-}$. Z represents transition metal, and may include one or more of Mn, Fe, Ni, Co, Cr, Cu, Ti, Zn, V, Zr, and Ce. m represents a valence state of $(ZO_y)^{m+}$. The halogen may be one or more of F, Cl, and Br.

The polyanionic compound may include one or more of $NaFePO_4$, $Na_3V_2(PO_4)_3$ (sodium vanadium phosphate, NVP for short), $Na_4Fe_3(PO_4)_2(P_2O_7)$, $NaM'PO_4F$, and $Na_3(VO_y)_2(PO_4)_2F_{3-2y}$ $(0 \leq y \leq 1)$. M' in $NaM'PO_4F$ may include one or more of V, Fe, Mn, and Ni.

The Prussian blue compound may be a type of compounds including sodium ions, transition metal ions, and cyanogen ions $(CN^-)$. The transition metal may include one or more of Mn, Fe, Ni, Co, Cr, Cu, Ti, Zn, V, Zr, and Ce. A non-limiting example of the Prussian blue compound may be $Na_aMe_bMe'_c(CN)_6$. Me and Me' may each independently be one or more of Ni, Cu, Fe, Mn, Co, and Zn. $0 < a \leq 2$, $0 < b < 1$, and $0 < c < 1$.

In some implementations, the positive electrode active material layer may further optionally include a binder. In a non-limiting example, the binder may include one or more of polyvinylidene fluoride (PVDF), polytetrafluoroethylene (PTFE), a vinylidene fluoride-tetrafluoroethylene-propylene terpolymer, a vinylidene fluoride-hexafluoropropylene-tetrafluoroethylene terpolymer, a tetrafluoroethylene-hexafluoropropylene copolymer, and a fluorine-containing acrylic resin.

In some implementations, the positive electrode active material layer may further optionally include a conductive agent. In a non-limiting example, the conductive agent may include one or more of superconducting carbon, acetylene black, carbon black, Ketjen black, carbon dots, carbon nanotubes, graphene, and carbon nanofibers.

In some implementations, the positive electrode plate may be prepared in the following manner: dispersing the components for preparing the positive electrode plate, for example, the positive electrode active material, the conductive agent, the binder, and any other components in a solvent to form a positive electrode slurry; and coating the positive electrode slurry on at least one side surface of the positive electrode current collector, followed by oven drying, cold pressing, and other procedures, to obtain the positive electrode plate. The solvent may be selected from, but is not limited to, any one listed in the foregoing embodiments, for example, N-methylpyrrolidone (NMP). The surface of the positive electrode current collector coated with the positive electrode slurry may be a single surface of the positive electrode current collector, or two surfaces of the positive electrode current collector. The surface of the positive electrode current collector coated with the positive electrode slurry may be a single surface of the positive electrode current collector, or two surfaces of the positive electrode current collector. A solid content of the positive electrode slurry may range from 40 wt% to 80 wt%. Viscosity of the positive electrode slurry at a room temperature may be adjusted to a range from 5000 mPa·s to 25000 mPa·s. When the positive electrode slurry is coated, a coating unit surface density based on a dry weight (where the

solvent is deducted) may range from 15 $mg/cm^2$ to 35 $mg/cm^2$. A compaction density of the positive electrode plate may range from 3.0 $g/cm^3$ to 3.6 $g/cm^3$, and optionally, from 3.3 $g/cm^3$ to 3.5 $g/cm^3$.

In the present application, the unit "mPa·s" refers to millibar second, the unit "$mg/cm^2$" refers to milligram/square centimeter, and the unit "$g/cm^3$" refers to gram/cubic centimeter.

Negative electrode plate

The negative electrode plate includes a negative electrode current collector and a negative electrode active material layer arranged on at least one surface of the negative electrode current collector, and the negative electrode active material layer includes a negative electrode active material.

In a non-limiting example, the negative electrode current collector has two surfaces opposite to each other in a thickness direction of the negative electrode current collector, and the negative electrode active material layer is arranged on either or both of the two opposite surfaces of the negative electrode current collector.

In some embodiments, the negative electrode current collector may use the foregoing composite current collector of the present application.

In some embodiments, the negative electrode current collector may use a metal foil or another composite current collector. For example, as the metal foil, a copper foil may be used. The another composite current collector may include a polymer material substrate and a metal layer formed on at least one surface of the polymer material substrate. The another composite current collector may be formed by forming a metal material on the polymer material substrate. In the negative electrode current collector, non-limiting examples of the metal material may include one or more of copper, a copper alloy, nickel, a nickel alloy, titanium, a titanium alloy, silver, a silver alloy, and the like. In the negative electrode current collector, non-limiting examples of the polymer material substrate may include one or more of polypropylene (PP), polyethylene terephthalate (PET), polybutylene terephthalate (PBT), polystyrene (PS), polyethylene (PE), and other substrates.

In some implementations, the negative electrode active material may be a negative electrode active material known in the art for a battery. In a non-limiting example, the negative electrode active material may include one or more of the following materials: artificial graphite, natural graphite, soft carbon, hard carbon, a silicon-based material, a tin-based material, lithium titanate, and the like. The silicon-based material may include one or more of an elemental silicon, a silicon oxide, a silicon-carbon composite, a silicon-nitrogen composite, and a silicon alloy. The tin-based material may include one or more of an elemental tin, a tin oxide, and a tin alloy. However, the present application is not limited to such materials, and another conventional material that can be used as the negative electrode active material for the battery may alternatively be used. These negative electrode active materials can be used alone or in combination with two or more.

In some implementations, the negative electrode active material layer may further optionally include a binder. The binder may include one or more of styrene-butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethyl chitosan (CMCS).

In some implementations, the negative electrode active material layer may further optionally include a conductive agent. The conductive agent may include one or more of superconducting carbon, acetylene black, carbon black, Ketjen black, carbon dots, carbon nanotubes, graphene, and carbon nanofibers.

In some implementations, the negative electrode active material layer may further optionally include another additive, such as a thickener (for example, sodium carboxymethyl cellulose (CMC-Na)).

In some implementations, the negative electrode plate may be prepared in the following manner: dispersing the components for preparing the negative electrode plate, for example, the negative electrode active material, the conductive agent, the binder, and any other components in a solvent (where a non-limiting example of the solvent is deionized water) to form a negative electrode slurry; and coating the negative electrode slurry on at least one side surface of the negative electrode current collector, followed by oven drying, cold pressing, and other procedures, to obtain the negative electrode plate. The surface of the negative electrode current collector coated with the negative electrode slurry may be a single surface of the negative electrode current collector, or two surfaces of the negative electrode current collector. A solid content of the negative electrode slurry may range from 40 wt% to 60 wt%. Viscosity of the negative electrode slurry at a room temperature may be adjusted to a range from 2000 mPa·s to 10000 mPa·s. When the negative electrode slurry is coated, a coating unit surface density based on a dry weight (where the solvent is deducted) may range from 75 $g/m^2$ to 220 $g/m^2$. A compaction density of the negative electrode plate may range from 1.0 $g/cm^3$ to 1.8 $g/cm^3$.

In the present application, the unit "$g/m^2$" refers to gram/square meter.

In some embodiments, the positive electrode current collector and/or the negative electrode current collector use the foregoing composite current collector of the present application. It may be understood that only the positive electrode current collector may use the foregoing composite current collector of the present application, or only the negative electrode current collector may use the foregoing composite current collector of the present application, or certainly, both the positive electrode current collector and the negative electrode current collector may use the foregoing composite current collector of the present application.

Electrolyte

The electrolyte is configured to conduct the ions between the positive electrode plate and the negative electrode plate. A type of the electrolyte is not particularly limited in the present application, and can be selected based on requirements. For example, the electrolyte can be liquid, gelled or all solid.

In some implementations, the electrolyte uses an electrolyte solution. The electrolyte solution includes electrolyte salt and a solvent.

In some implementations, the electrolyte salt may include one or more of lithium hexafluorophosphate ($LiPF_6$), lithium tetrafluoroborate ($LiBF_4$), lithium perchlorate ($LiClO_4$), lithium hexafluoroarsenate ($LiAsF_6$), lithium bis(fluorosulfonyl)imide (LiFSI), lithium bis(trifluoromethanesulfonyl)imide (LiTFSI), lithium triflate (LiTFS), lithium difluorophosphate ($LiPO_2F_2$), lithium difluoro(oxalato)borate (LiDFOB), lithium bis(oxalate)borate (LiBOB), lithium difluoro bis(oxalato) phosphate (LiDFOP), and lithium tetrafluoro(oxalato)phosphate (LiTFOP).

In some implementations, the solvent may include one or more of ethylene carbonate (EC,

O O O ),

propylene carbonate (PC,

O O O ),

ethyl methyl carbonate (EMC), diethyl carbonate (DEC), dimethyl carbonate (DMC), dipropyl carbonate (DPC), methyl propyl carbonate (MPC), ethyl propyl carbonate (EPC), butylene carbonate

( O O O ),

fluoroethylene carbonate (FEC), methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, methyl ethyl sulfone, and diethyl sulfone.

In some implementations, the electrolyte solution may further optionally include an additive. For example, the additive may include a negative electrode film-forming additive, a positive electrode film-forming additive, and may further include an additive that can improve certain performance of the battery, for example, an additive improving overcharge performance of the battery or an additive improving high-temperature or low-temperature performance of the battery.

In some implementations, the additive in the electrolyte solution may include, but is not limited to, one or more of fluoroethylene carbonate (FEC), difluoroethylene carbonate (DFEC), trifluoropropylene carbonate (TFPC), and the like.

Separator

In some implementations, the secondary battery further includes the separator. A type of the separator is not particularly limited in the present application, and any well-known porous-structure separator with good chemical stability and mechanical stability can be selected.

In some implementations, a material of the separator may include one or more of glass fiber, non-woven cloth, polyethylene, polypropylene, and polyvinylidene fluoride. The separator may be a single-layer thin film or a multi-layer composite film, and is not particularly limited. When the separator is the multi-layer composite film, materials of layers may be the same or different, and are not particularly limited.

In some implementations, a thickness of the separator ranges from 6 μm to 40 μm, and optionally, ranges from 12 μm to 20 μm.

In some implementations, the positive electrode plate, the negative electrode plate, and the separator may be

made into an electrode assembly by a winding process or a laminating process.

In some implementations, the secondary battery may include an outer package. The outer package may be configured to encapsulate the electrode assembly and the electrolyte.

In some implementations, the outer package of the secondary battery may be a hard shell, such as a hard plastic shell, an aluminum shell, or a steel shell. The outer package of the secondary battery may alternatively be a soft pack, such as a pouch-type soft pack. A material of the soft pack may be plastic, and further, a non-limiting example of the plastic may include one or more of polypropylene, polybutylene terephthalate, polybutylene succinate, and the like.

The secondary battery includes at least one battery cell. The secondary battery may include one or more battery cells.

In the present application, unless otherwise specified, the "battery cell" refers to a basic unit that can implement interconversion of chemical energy and electric energy, and further, generally includes at least the positive electrode plate, the negative electrode plate, and the electrolyte. During charge/discharge of a battery, active ions are intercalated and de-intercalated back and forth between the positive electrode plate and the negative electrode plate. The electrolyte is configured to conduct the active ions between the positive electrode plate and the negative electrode plate.

A shape of the battery cell is not particularly limited in the present application, and may be cylindrical, prismatic, or any other shape. For example, FIG. 3 shows a battery cell 5 having a prismatic structure as an example.

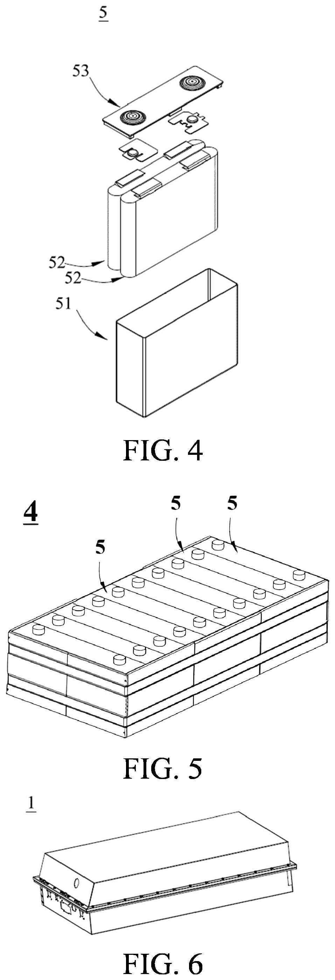

In some implementations, refer to FIG. 4, the outer package may include a housing 51 and a cover plate 53. The housing 51 may include a bottom plate and a side plate connected to the bottom plate, and an accommodating cavity is enclosed by the bottom plate and the side plate. The housing 51 has an opening communicating with the accommodating cavity, and the cover plate 53 can cover the opening to seal the accommodating cavity. The positive electrode plate, the negative electrode plate, and the separator may be made into an electrode assembly 52 by a winding process or a laminating process. The electrode assembly 52 is encapsulated within the accommodating cavity. The electrolyte solution infiltrates in the electrode assembly 52. A quantity of electrode assemblies 52 included in the battery cell 5 may be one or more, and may be selected by a person skilled in the art based on an actual requirement.

The secondary battery may be a battery module 4 or a battery pack 1.

The battery module includes at least one battery cell. A quantity of battery cells included in the battery module may be one or more, and a person skilled in the art may select a proper quantity based on application and a capacity of the battery module.

FIG. 5 shows a battery module 4 as an example. Refer to FIG. 5, in the battery module 4, a plurality of battery cells 5 may be arranged sequentially along a length direction of the battery module 4. Certainly, the plurality of battery cells 5 may alternatively be arranged in any other manner. Further, the plurality of battery cells 5 may be fixed by using a fastener.

Optionally, the battery module 4 may further include a shell having an accommodating space, and the plurality of battery cells 5 are accommodated in the accommodating space.

In some implementations, the battery module may further be assembled into a battery pack. A quantity of battery modules included in the battery pack may be one or more, and a person skilled in the art may select a proper quantity based on application and a capacity of the battery pack.

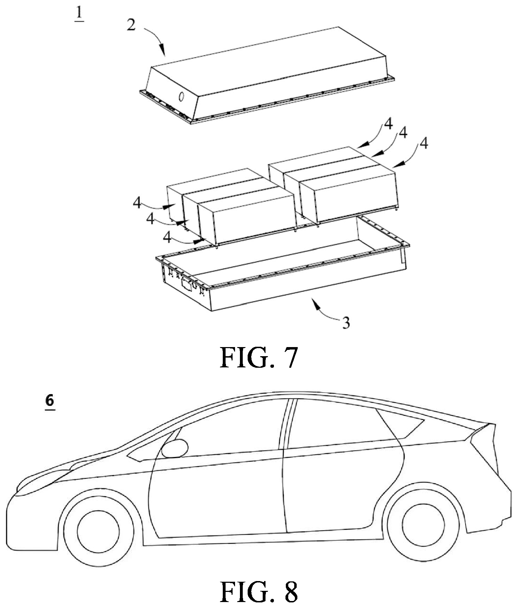

FIG. 6 and FIG. 7 show a battery pack 1 as an example. Refer to FIG. 6 and FIG. 7, the battery pack 1 may include a battery box and a plurality of battery modules 4 disposed in the battery box. The battery box includes an upper box body 2 and a lower box body 3. The upper box body 2 can cover the lower box body 3, to form an enclosed space configured to accommodate the battery modules 4. The plurality of battery modules 4 may be arranged in the battery box in any manner.

In addition, the present application further provides a power consuming apparatus. The power consuming apparatus includes the secondary battery provided in the present application. The secondary battery may serve as a power supply of the power consuming apparatus, or may serve as an energy storage unit of the power consuming apparatus. The power consuming apparatus may include, but is not limited to, a mobile device, an electric vehicle, an electric train, a ship, a satellite, an energy storage system, and the like. The mobile device may be, for example, a mobile phone or a notebook computer. The electric vehicle may be, for example, a pure electric vehicle, a hybrid electric vehicle, a plug-in hybrid electric vehicle, an electric bicycle, an electric scooter, an electric golf cart, an electric truck, or the like, but is not limited thereto.

The secondary battery may be selected based on a use requirement of the power consuming apparatus.

FIG. 8 shows a power consuming apparatus 6 as an example. The power consuming apparatus is a pure electric vehicle, a hybrid electric vehicle, a plug-in hybrid electric vehicle, or the like. To satisfy requirements of the power consuming apparatus for high power and a high energy density of the secondary battery, the battery pack or the battery module may be used.

In another example, the apparatus may be a mobile phone, a tablet computer, a notebook computer, or the like. The apparatus is generally required to be thin and light, and may use the secondary battery as a power supply.

Examples of the present application are described below. The examples described below are exemplary and are only intended to explain the present application, and cannot be understood as limitations to the present application. If neither technology nor condition is specified in the examples, the examples may be performed according to technologies

or conditions described in literatures in the art or a product specification. The used reagents or instruments without manufacturer indicated are all conventional products that may be purchased in the market.

Example 1

(1) A preparation method of a composite current collector includes the following steps:

(1.1) an aluminum foil intermediate with a thickness ranging from 3 μm to 5 μm and a grain size being 2000 nm was prepared by using a cold-rolled aluminum foil and an annealing process that controls the aluminum foil;
(1.2) a passivator potassium dichromate was formulated into a passivated slurry, and the passivated slurry was uniformly coated on a surface of the aluminum foil intermediate in a gravure manner, to form a passivation layer with a thickness being 100 nm;
(1.3) a polyurethane binding slurry was coated on a surface of the passivation layer away from the aluminum foil intermediate in a gravure manner, to form a binding layer with a thickness being 500 nm;
(1.4) after the aluminum foil intermediate having the binding layer obtained in step (1.3) was baked by using an oven of 110 degrees Celsius (°C), the aluminum foil intermediate was separately attached to two surfaces in a thickness direction of a support layer, and curing was performed under a condition of 80°C for 72 hours (h), to obtain a first semi-finished product, where a thickness of the support layer was 6 μm, and a material of the support layer was PET;
(1.5) corrosion thinning was performed on the aluminum foil intermediate in the first semi-finished product by using a sodium hydroxide solution of 60 gram/liter (g/L), to form a first conductive layer with a thickness being 800 nm, where a grain size of aluminum (first metal material) at the first conductive layer was 2000 nm, bright dipping was performed by using water and 68% nitric acid after the aluminum foil intermediate was corroded to a design thickness, spraying was performed by using water after the dipping, residual water was squeezed out by using a liquid squeezing roller, and winding was finally performed after baking was performed by using an oven of 80°C, to obtain a second semi-finished product; and
(1.6) the second semi-finished product processed in step (1.5) was disposed in a vacuum plating chamber, vacuum pumping was performed to $10^{-2}$ pascal (Pa), high-purity aluminum filaments in a metal evaporation chamber were melted and evaporated at a high temperature ranging from 1200°C to 2000°C, the evaporated metal was passed through a cooling system in the vacuum plating chamber, and the metal was finally deposited on a surface of the first conductive layer, to form a second conductive layer, where a grain size of aluminum (second metal material) at the second conductive layer was 200 nm. The obtained composite current collector includes the support layer, the binding layer, the passivation layer, the first conductive layer, and the second conductive layer. The binding layer, the passivation layer, the first conductive layer, and the second conductive layer are sequentially laminated, along a direction away from the support layer, on two surfaces of the support layer that are in a thickness direction of the support layer.

(2) A preparation method of a secondary battery includes the following steps:

(2.1) Preparation of a positive electrode plate

A positive electrode active material $LiNi_{0.8}Co_{0.1}Mn_{0.1}O_2$, conductive carbon black SP, and a binder PVDF were dispersed into a solvent NMP according to a weight ratio of 98:1:1, and were uniformly mixed, to obtain a positive electrode slurry. The positive electrode slurry was uniformly coated on two side surfaces of the composite current collector prepared in step (1), followed by oven drying and cold pressing, to obtain the positive electrode plate, where a compaction density of the positive electrode plate was 3.4 g/cm$^3$.

(2.2) Preparation of a negative electrode plate

A negative electrode active material graphite, a thickener sodium carboxymethyl cellulose, a binder styrene-butadiene rubber, and a conductive agent acetylene black were mixed according to a mass ratio of 97:1:1:1, and deionized water was added, to obtain a negative electrode slurry under action of a vacuum stirrer. The negative electrode slurry was uniformly coated on two side surfaces of a copper foil. The copper foil was air dried at a room temperature and then transferred to an oven of 120°C to be dried for 1h, followed by oven drying and slitting, to obtain the negative electrode plate, where a compaction density of the negative electrode plate was 1.6 g/cm$^3$.

(2.3) Separator

A separator on which PP was composited on two sides of PE (PP/PE/PP) was selected.

(2.4) Preparation of an electrolyte solution

An organic solvent was a mixed solution including ethylene carbonate (EC) and ethyl methyl carbonate (EMC), where a volume ratio of EC to EMC was 30:70. Fully dried lithium salt $LiPF_6$ was dissolved in the organic solvent in an argon atmosphere glove box with a water content < 10 ppm, and mixing was uniformly performed, to obtain the electrolyte solution. A concentration of the lithium salt was 1 mol/liter (mol/L).

(2.5) Preparation of the battery

The positive electrode plate, the separator, and the negative electrode plate were sequentially laminated, so that the separator was located between the positive electrode plate and the negative electrode plate for isolation. After a bare battery cell was obtained through winding, rolling-welding conversion was performed in a manner of covering edges on two surfaces by using metal, to weld a tab. The bare battery cell was packaged in an aluminum plastic film and baked at 80°C to remove water, and then a non-aqueous electrolyte was injected, and sealing was performed, followed by processes such as preserving, hot and cold pressing, formation, clamping, and capacitance grading, to obtain the finished battery.

Examples 2 to 32

Examples 2 to 32 are basically the same as Example 1, and a difference lies in that the preparation method of the composite current collector in step (1) differs. Specifically, the thickness of the first conductive layer, the thickness of the second conductive layer, the grain size of the first metal material, and the grain size of the second metal material are changed.

Comparative example 1

Comparative example 1 is basically the same as Example 1, and a difference lies in that the preparation method of the composite current collector in step (1) differs. Specifically, step (1.6) is omitted, to be specific, no second conductive layer is disposed in the composite current collector.

Product parameters of the composite current collectors prepared in Examples 1 to 32 and Comparative example 1 are shown in Table 1.

Performance test

(1) Method for testing the thicknesses of the first conductive layer, the second conductive layer, the passivation layer, the binding layer, and the support layer, and thickness fluctuation of the first conductive layer and the second conductive layer

A cross-section sample of the composite current collector was prepared by using a liquid-nitrogen quenching method or an argon ion etching method, and a secondary electron phase morphology of a cross section of the sample is observed by using a scanning electron microscope (SEM) under magnification (1000 magnifications to 30000 magnifications), so that the thickness of the first conductive layer, the second conductive layer, the passivation layer, the binding layer, or the support layer can be measured, where a minimum resolution can be nanoscale.

Thickness fluctuation (%) of the first conductive layer and the second conductive layer = (H2 - H1) / H1 * 100%.

H1 represents a design value of a total thickness of the first conductive layer and the second conductive layer, and H2 represents an actually measured value of the total thickness of the first conductive layer and the second conductive layer in the cross-section sample of the composite current collector.

(2) Method for testing the grain sizes of the first metal material and the second metal material

The first conductive layer or the second conductive layer was magnified by 10000 magnifications to 30000 magnifications by using the SEM, a grain size of a surface was observed, and sizes of 300 grains were randomly measured to obtain an average value, where a minimum resolution can be nanoscale.

Grain size of the first metal material = sum of grain sizes of 300 first metal materials / 300.

Grain size of the second metal material = sum of grain sizes of 300 second metal materials / 300.

(3) Method for testing the tensile modulus of the composite current collector

The composite current collector was slitted into ten samples with a width being 15 millimeters (mm) and a length being 15 centimeters (cm) along a direction MD or a direction TD by using a standard sampler. The samples were fixed at a clamp of a tensile testing machine, where a speed was set to 50 millimeters/minute (mm/min), and a gauge length between clamps was 50 mm, to perform tensile testing. Modulus calculation was performed by using 1% of strength corresponding to extension. Tensile modulus (GPa) = (strength / 1%) / 1000. The tensile modulus of the composite current collector was an average value of tensile moduli of the ten test samples. The direction MD of the composite current collector refers to a mechanical direction or a longitudinal direction of the composite current collector, and the direction TD of the composite current collector refers to a direction perpendicular to the direction MD of the composite current collector, that is, a transverse direction of the composite current collector.

(4) Method for testing the fracture strength of the composite current collector

The composite current collector was slitted into ten samples with a width being 15 mm and a length being 15 cm along the direction MD or the direction TD by using the standard sampler. The samples were fixed at the clamp of the tensile testing machine, where a speed was set to 50 mm/min, and a gauge length between clamps was 50 mm, to perform tensile testing. A corresponding maximum strength and extension in a tensile rupture state were obtained.

Fracture strength (MPa) of the composite current collector = sum of maximum tensile strengths of the ten samples / 10.

(5) Method for testing the compactness of the composite current collector and the compactness of the first conductive layer

A flat sample of the second semi-finished product or a flat sample of the composite current collector was disposed on an operation desk of a CCD optical microscope. A light source was turned on at the back of the operation desk, and a light source of the microscope was turned off. Photos of three regions of the sample in a dark field situation were shot. The three images stored in the CCD were selected by using image processing software ImageJ, to calculate compactness percentage values M.

$$\text{Average value } M = \text{sum of the values } M \text{ of the three test regions} / 3.$$

A compactness tested by using the second semi-finished product is the compactness of the first conductive layer. A compactness tested by using the composite current collector is the compactness of the composite current collector.

(6) Method for testing a shrinkage rate of the tab

Sizes of positive electrode tabs were measured at intervals of 50 meters, to calculate the shrinkage rate of the tab. A measurement method is that a table region after coating and drying was aligned by using a film ruler, a width size was measured, and then the width size is compared with an original size of the tab, to calculate the shrinkage rate. Shrinkage rate = (original size of the tab - width size of the tab) / original size of the tab) * 100%.

$$\text{Shrinkage rate of the tab} = \text{sum of shrinkage rates of ten tabs} / 10.$$

(7) Method for testing a welding tensile force of the tab

The welding tensile force of the tab after welding was measured by using a Gotech tensile testing machine. A welding region (the tab, a welding mark, and an active material layer) of the positive electrode plate was selected and cut into samples with a width being 50 mm and a length being 60 mm. A region of the welding mark was located at a middle position of the sample. The sample was stretched at a speed of 5 mm/min, where a specification of the welding tensile force was required to be ≥ 25 newtons (N), and a maximum force value when welding is broken was read. One sample was obtained every meter, and ten samples were totally selected for testing. Finally, an average value of welding tensile forces of the ten samples was obtained.

(8) Method for testing a U-shaped resistance after the electrode plate is rolled and welded

A welded electrode plate was cut into samples with a size the same as that of the battery core, and a resistance between two positive electrode tabs was measured by using an internal resistance tester.

U-shaped resistance after the electrode plate is rolled and welded = sum of U-shaped resistance values of ten samples / 10.

(9) Method for testing the DCR.

The DCR was tested by using a battery test device. A specific test method is as follows: a battery capacity was adjusted to 50% SOC, a voltage V1 was recorded, and discharging was performed at 4C for 30s, to obtain a voltage value V2. DCR = (V1 - V2) / 4C. 4C is a discharging current.

$$\text{DCR value of the battery} = \text{sum of DCR values of ten samples} / 10.$$

Performance test results of the composite current collectors prepared in Examples 1 to 32 and Comparative example 1 are shown in Table 2.

Table 1

| Group | Thickness of the first conductive layer / nm | Thickness of the second conductive layer / nm | Ratio of the grain size of the first metal material to the grain size of the second metal material | Difference between the grain size of the first metal material and the grain size of the second metal material | Grain size of the first metal material / nm | Grain size of the second metal material / nm | Thickness of the passivation layer / nm | Thickness of the binding layer / nm | Thickness of the support layer / µm | Ratio of the thickness of the first conductive layer to the thickness of the second conductive layer |
|---|---|---|---|---|---|---|---|---|---|---|
| Example 1 | 800 | 300 | 10.0 | 1800 | 2000 | 200 | 100 | 500 | 6 | 2.7 |
| Example 2 | 500 | 300 | 10.0 | 1800 | 2000 | 200 | 100 | 500 | 6 | 1.7 |
| Example 3 | 600 | 300 | 10.0 | 1800 | 2000 | 200 | 100 | 500 | 6 | 2.0 |
| Example 4 | 1200 | 300 | 10.0 | 1800 | 2000 | 200 | 100 | 500 | 6 | 4.0 |
| Example 5 | 1500 | 300 | 10.0 | 1800 | 2000 | 200 | 100 | 500 | 6 | 5.0 |
| Example 6 | 400 | 300 | 10.0 | 1800 | 2000 | 200 | 100 | 500 | 6 | 1.3 |
| Example 7 | 1600 | 300 | 10.0 | 1800 | 2000 | 200 | 100 | 500 | 6 | 5.3 |
| Example 8 | 800 | 100 | 10.0 | 1800 | 2000 | 200 | 100 | 500 | 6 | 8.0 |
| Example 9 | 800 | 200 | 10.0 | 1800 | 2000 | 200 | 100 | 500 | 6 | 4.0 |
| Example 10 | 800 | 400 | 10.0 | 1800 | 2000 | 200 | 100 | 500 | 6 | 2.0 |
| Example 11 | 800 | 500 | 10.0 | 1800 | 2000 | 200 | 100 | 500 | 6 | 1.6 |
| Example 12 | 800 | 700 | 10.0 | 1800 | 2000 | 200 | 100 | 500 | 6 | 1.1 |
| Example 13 | 800 | 50 | 10.0 | 1800 | 2000 | 200 | 100 | 500 | 6 | 16.0 |
| Example 14 | 800 | 800 | 10.0 | 1800 | 2000 | 200 | 100 | 500 | 6 | 1.0 |
| Example 15 | 800 | 900 | 10.0 | 1800 | 2000 | 200 | 100 | 500 | 6 | 0.9 |
| Example 16 | 800 | 80 | 10.0 | 1800 | 2000 | 200 | 100 | 500 | 6 | 10.0 |
| Example 17 | 800 | 300 | 2.5 | 300 | 500 | 200 | 100 | 500 | 6 | 2.7 |
| Example 18 | 800 | 300 | 5.0 | 800 | 1000 | 200 | 100 | 500 | 6 | 2.7 |
| Example 19 | 800 | 300 | 7.5 | 1300 | 1500 | 200 | 100 | 500 | 6 | 2.7 |
| Example 20 | 800 | 300 | 12.5 | 2300 | 2500 | 200 | 100 | 500 | 6 | 2.7 |
| Example 21 | 800 | 300 | 15.0 | 2800 | 3000 | 200 | 100 | 500 | 6 | 2.7 |

(continued)

| Group | Thickness of the first conductive layer / nm | Thickness of the second conductive layer / nm | Ratio of the grain size of the first metal material to the grain size of the second metal material | Difference between the grain size of the first metal material and the grain size of the second metal material | Grain size of the first metal material / nm | Grain size of the second metal material / nm | Thickness of the passivation layer / nm | Thickness of the binding layer / nm | Thickness of the support layer / μm | Ratio of the thickness of the first conductive layer to the thickness of the second conductive layer |
|---|---|---|---|---|---|---|---|---|---|---|
| Example 22 | 800 | 300 | 16.5 | 3100 | 3300 | 200 | 100 | 500 | 6 | 2.7 |
| Example 23 | 800 | 300 | 2.0 | 200 | 400 | 200 | 100 | 500 | 6 | 2.7 |
| Example 24 | 800 | 300 | 17.5 | 3300 | 3500 | 200 | 100 | 500 | 6 | 2.7 |
| Example 25 | 800 | 300 | 40.0 | 1950 | 2000 | 50 | 100 | 500 | 6 | 2.7 |
| Example 26 | 800 | 300 | 50.0 | 1960 | 2000 | 40 | 100 | 500 | 6 | 2.7 |
| Example 27 | 800 | 300 | 20.0 | 1900 | 2000 | 100 | 100 | 500 | 6 | 2.7 |
| Example 28 | 800 | 300 | 13.3 | 1850 | 2000 | 150 | 100 | 500 | 6 | 2.7 |
| Example 29 | 800 | 300 | 8.0 | 1750 | 2000 | 250 | 100 | 500 | 6 | 2.7 |
| Example 30 | 800 | 300 | 6.7 | 1700 | 2000 | 300 | 100 | 500 | 6 | 2.7 |
| Example 31 | 800 | 300 | 66.7 | 1970 | 2000 | 30 | 100 | 500 | 6 | 2.7 |
| Example 32 | 800 | 300 | 5.7 | 1650 | 2000 | 350 | 100 | 500 | 6 | 2.7 |
| Comparative example 1 | 800 | / | / | / | 2000 | / | 100 | 500 | 6 | / |

Table 2

| Number | Compactness of the composite current collector / % | Compactness of the first conductive layer / % | Thickness fluctuation of the first conductive layer and the second conductive layer / % | Fracture strength of the composite current collector along the direction MD / MPa | Fracture strength of the composite current collector along the direction TD / MPa | Tensile modulus of the composite current collector along the direction MD / GPa | Tensile modulus of the composite current collector along the direction TD / GPa | Shrinkage rate of the tab / % | Welding tensile force of the tab / N | U-shaped resistance after the electrode plate is rolled and welded / mΩ | DCR value of the battery / mΩ |
|---|---|---|---|---|---|---|---|---|---|---|---|
| Example 1 | 93 | 70 | 13 | 188 | 194 | 7.2 | 7.9 | 1 | 47 | 86 | 0.42 |
| Example 2 | 92 | 60 | 15 | 198 | 201 | 6.5 | 7.1 | 3 | 46 | 88 | 0.46 |
| Example 3 | 92 | 65 | 14 | 190 | 196 | 6.7 | 7.3 | 2 | 47 | 85 | 0.43 |
| Example 4 | 93 | 75 | 12 | 182 | 185 | 7.9 | 8.5 | 0 | 43 | 86 | 0.43 |
| Example 5 | 95 | 85 | 12 | 171 | 172 | 8.9 | 9.5 | 0 | 32 | 103 | 0.48 |
| Example 6 | 85 | 55 | 18 | 161 | 163 | 5.0 | 5.1 | 10 | 23 | 122 | 0.68 |
| Example 7 | 95 | 86 | 10 | 168 | 171 | 9.5 | 10.0 | 0 | 17 | 157 | 1.1 |
| Example 8 | 91 | 70 | 13 | 173 | 176 | 6.7 | 7.0 | 1 | 45 | 87 | 0.41 |
| Example 9 | 92 | 70 | 12 | 184 | 188 | 7.0 | 7.5 | 1 | 44 | 89 | 0.43 |
| Example 10 | 92 | 70 | 11 | 191 | 197 | 7.7 | 8.1 | 1 | 45 | 85 | 0.42 |
| Example 11 | 93 | 70 | 10 | 193 | 199 | 8.5 | 9.1 | 0 | 43 | 86 | 0.44 |
| Example 12 | 95 | 70 | 5 | 178 | 181 | 10.1 | 10.3 | 0 | 35 | 99 | 0.47 |
| Example 13 | 80 | 70 | 20 | 166 | 167 | 5.2 | 5.3 | 5 | 22 | 130 | 0.78 |
| Example 14 | 96 | 70 | 5 | 177 | 181 | 10.5 | 11.0 | 0 | 20 | 146 | 0.88 |
| Example 15 | 91 | 70 | 4 | 182 | 183 | 11.1 | 11.7 | 0 | 20 | 147 | 0.88 |
| Example 16 | 87 | 70 | 17 | 163 | 165 | 5.0 | 5.1 | 6 | 21 | 131 | 0.78 |
| Example 17 | 93 | 70 | 13 | 183 | 185 | 7.5 | 8.1 | 1 | 45 | 84 | 0.43 |
| Example 18 | 93 | 70 | 12 | 180 | 183 | 7.3 | 7.7 | 1 | 43 | 87 | 0.44 |
| Example 19 | 93 | 70 | 13 | 179 | 181 | 7.2 | 7.5 | 1 | 44 | 85 | 0.43 |
| Example 20 | 93 | 70 | 13 | 177 | 179 | 6.7 | 7.1 | 2 | 45 | 85 | 0.44 |
| Example 21 | 93 | 70 | 12 | 173 | 176 | 5.4 | 5.7 | 4 | 35 | 100 | 0.48 |

(continued)

| Number | Compactn ess of the composite current collector / % | Compactn ess of the first conductive layer / % | Thicknes s fluctuati on of the first conducti ve layer and the second conducti ve layer / % | Fracture strength of the composi te current collector along the directio n MD / MPa | Fracture strength of the composi te current collector along the directio n TD / MPa | Tensile modulus of the composi te current collector along the directio n MD / GPa | Tensile modulus of the composi te current collector along the directio n TD / GPa | Shrinka ge rate of the tab / % | Weldin g tensile force of the tab / N | U-shaped resistan ce after the electrod e plate is rolled and welded / mΩ | DCR value of the batter y / mΩ |
|---|---|---|---|---|---|---|---|---|---|---|---|
| Example 22 | 93 | 70 | 12 | 170 | 173 | 5.3 | 5.6 | 4 | 33 | 101 | 0.49 |
| Example 23 | 93 | 70 | 13 | 169 | 175 | 7.8 | 8.1 | 1 | 20 | 145 | 0.88 |
| Example 24 | 93 | 70 | 13 | 164 | 167 | 5.1 | 5.2 | 6 | 22 | 130 | 0.78 |
| Example 25 | 93 | 70 | 8 | 198 | 201 | 8.5 | 9.1 | 0 | 43 | 83 | 0.43 |
| Example 26 | 93 | 70 | 8 | 196 | 199 | 8.2 | 8.7 | 0 | 34 | 100 | 0.49 |
| Example 27 | 93 | 70 | 9 | 194 | 198 | 8.1 | 8.6 | 0 | 45 | 82 | 0.42 |
| Example 28 | 93 | 70 | 10 | 190 | 195 | 7.9 | 8.3 | 0 | 44 | 84 | 0.44 |
| Example 29 | 93 | 70 | 12 | 183 | 185 | 6.7 | 7.1 | 2 | 44 | 88 | 0.45 |
| Example 30 | 93 | 70 | 13 | 171 | 174 | 5.2 | 5.3 | 5 | 26 | 109 | 0.52 |
| Example 31 | 93 | 70 | 4 | 196 | 201 | 9.6 | 10.1 | 0 | 19 | 155 | 1.1 |
| Example 32 | 89 | 70 | 14 | 163 | 166 | 5.0 | 5.1 | 8 | 21 | 131 | 0.78 |
| Comparative example 1 | 70 | 70 | 50 | 154 | 157 | 4.3 | 4.5 | 50 | 13 | 186 | 1.8 |

In Table 2, the unit "mΩ" refers to a milliohm.

The following can be learned from Table 1 and Table 2:

No second conductive layer is disposed in Comparative example 1. The fracture strength and the tensile modulus of the composite current collector and the welding tensile force of the tab are significantly higher in Examples 1 to 32 in comparison with those in Comparative example 1, and the shrinkage rate of the tab, the U-shaped resistance after the electrode plate is rolled and welded, and the DCR value of the battery are significantly lower in the composite current collector in Examples 1 to 32. It indicates that, in the present application, the second conductive layer is disposed, and the grain size of the second metal material at the second conductive layer is smaller than the grain size of the first metal material at the first conductive layer, so that the fracture strength and the tensile modulus of the composite current collector are effectively improved, and the problems of wrinkling and shrinking in the tab region of the composite current collector are alleviated.

The foregoing descriptions of the embodiments are intended to emphasize differences between the embodiments. Mutual reference may be made to the same or similar parts. For brevity, details are not described herein again.

It should be noted that the present application is not limited to the foregoing implementations. The foregoing implementations are exemplary only, and any implementation within the scope of the technical solutions of the present application that has substantially the same composition and has the same effects as the technical idea is encompassed in the technical scope of the present application. In addition, without departing from the gist of the present application, various modifications that may be conceived by those skilled in the art to the implementations, and other modes constructed by combining some of the constituent elements of the implementations are also included in the scope of the present application.

## Claims

1. A composite current collector, comprising a support layer, and a binding layer, a first conductive layer, and a second conductive layer that are sequentially laminated on at least one surface of the support layer, wherein the first conductive layer comprises a first metal material, the second conductive layer comprises a second metal material, and a grain size of the second metal material is smaller than a grain size of the first metal material.

2. The composite current collector according to claim 1, wherein a ratio of the grain size of the first metal material to the grain size of the second metal material ranges from 2 to 50.

3. The composite current collector according to claim 1 or 2, wherein the ratio of the grain size of the first metal material to the grain size of the second metal material ranges from 2.5 to 40.

4. The composite current collector according to any one of claims 1 to 3, wherein a difference between the grain size of the first metal material and the grain size of the second metal material ranges from 200 nm to 3300 nm.

5. The composite current collector according to any one of claims 1 to 4, wherein the difference between the grain size of the first metal material and the grain size of the second metal material ranges from 300 nm to 3100 nm.

6. The composite current collector according to any one of claims 1 to 5, wherein the grain size of the second metal material ranges from 50 nm to 300 nm.

7. The composite current collector according to any one of claims 1 to 6, wherein the grain size of the first metal material ranges from 500 nm to 3000 nm.

8. The composite current collector according to any one of claims 1 to 7, wherein the first metal material and the second metal material each independently comprise one or more of aluminum and an aluminum alloy.

9. The composite current collector according to any one of claims 1 to 8, wherein the composite current collector has one or more of the following features:

   (a) a ratio of a thickness of the first conductive layer to a thickness of the second conductive layer ranges from 1 to 10;
   (b) the thickness of the first conductive layer ranges from 500 nm to 1500 nm; and
   (c) the thickness of the second conductive layer ranges from 100 nm to 700 nm.

10. The composite current collector according to any one of claims 1 to 9, wherein the ratio of the thickness of the first conductive layer to the thickness of the second conductive layer ranges from 1.5 to 8.

11. The composite current collector according to any one of claims 1 to 10, wherein a compactness of the composite current collector ≥ 90%.

12. The composite current collector according to any one of claims 1 to 11, wherein a compactness of the first conductive layer ≥ 60%.

13. The composite current collector according to any one of claims 1 to 12, wherein a tensile modulus of the composite current collector ranges from 5 GPa to 12 GPa.

14. The composite current collector according to any one of claims 1 to 13, wherein a fracture strength of the composite current collector ≥ 160 MPa.

15. The composite current collector according to any one of claims 1 to 14, wherein the composite current collector further comprises a passivation layer, and the passivation layer is disposed between the binding layer and the first conductive layer.

16. The composite current collector according to claim 15, wherein the passivation layer comprises a passivator, and the passivator comprises one or more of an organic phosphate, a chromate, a dichromate, $Al_2O_3$, $SiO_2$, and $Si_3N_4$.

17. The composite current collector according to any one of claims 1 to 16, wherein a thickness of the binding layer ranges from 300 nm to 700 nm.

18. The composite current collector according to any one of claims 1 to 17, wherein a thickness of the support layer ranges from 2 μm to 10 μm.

19. The composite current collector according to any one of claims 1 to 18, wherein the support layer comprises one or more of a polymer material and a polymer matrix composite material.

20. A preparation method of a composite current collector, wherein the method comprises the following steps: forming, on at least one surface of a support layer, a binding layer, a first conductive layer, and a second conductive layer that are sequentially laminated, wherein the first conductive layer comprises a first metal material, the second conductive layer comprises a second metal material, and a grain size of the second metal material is smaller than a grain size of the first metal material.

21. The preparation method according to claim 20, wherein the step of forming a second conductive layer comprises: disposing the second conductive layer on a surface of the first conductive layer by using a vapor deposition method and/or a magnetron sputtering method.

22. The preparation method according to claim 20 or 21, wherein the step of forming, on at least one surface of a support layer, a binding layer and a first conductive layer that are sequentially laminated comprises: disposing a first slurry comprising a binder on a surface of at least one of the support layer and the first conductive layer, to solidify the first slurry and form the binding layer.

23. The preparation method according to any one of claims 20 to 22, further comprising: forming a passivation layer between the binding layer and the first conductive layer, wherein
the forming a passivation layer comprises: disposing a second slurry comprising a passivator on one surface of the first conductive layer, to solidify the second slurry and form the passivation layer.

24. An electrode plate, comprising at least one of the composite current collector according to any one of claims 1 to 19 and a composite current collector prepared by using the preparation method according to any one of claims 20 to 23.

25. A battery, comprising at least one of the composite current collector according to any one of claims 1 to 19, a composite current collector prepared by using the preparation method according to any one of claims 20 to 23, and the electrode plate according to claim 24.

**26.** A power consuming apparatus, comprising the battery according to claim 25.

7
74
73
72
71
7
74
73
75
72
71

FIG. 1

FIG. 2

5

FIG. 3

5
53
52
52
51

FIG. 4

4
5
5
5

FIG. 5

1

FIG. 6

1
2
4
4
4
4
4
4
3
6

FIG. 7

FIG. 8

**INTERNATIONAL SEARCH REPORT**

International application No. **PCT/CN2024/114578**

**A. CLASSIFICATION OF SUBJECT MATTER**

H01M4/66(2006.01)i； H01M10/0525(2010.01)i； C23C14/20(2006.01)i； C23C14/24(2006.01)i

According to International Patent Classification (IPC) or to both national classification and IPC

**B. FIELDS SEARCHED**

Minimum documentation searched (classification system followed by classification symbols)

IPC:H01M4/-; H01M10/-; C23C14/-

Documentation searched other than minimum documentation to the extent that such documents are included in the fields searched

Electronic data base consulted during the international search (name of data base and, where practicable, search terms used)

CNTXT, CNKI, VEN, ENTXTC, ISI_Web of Science: 导电层, 集流体, 金属, 晶粒, 晶粒尺寸, 粘结, 粘结层, 支撑, 粘接, 拉伸模量, 断裂强度, 晶界, 打皱, current collector, bonding layer?, bonding layer?, crystal grain?, grain?, grain boundary

**C. DOCUMENTS CONSIDERED TO BE RELEVANT**

| Category* | Citation of document, with indication, where appropriate, of the relevant passages | Relevant to claim No. |
|---|---|---|
| X | CN 116895761 A (HEFEI YUANYUAN TECHNOLOGY CO., LTD.) 17 October 2023 (2023-10-17)<br>description, paragraphs 0002 and 0006, paragraph 0032-0034, embodiment 2, and table 1 | 1-16, 18-21, 23-26 |
| Y | CN 116895761 A (HEFEI YUANYUAN TECHNOLOGY CO., LTD.) 17 October 2023 (2023-10-17)<br>description, paragraphs 0002 and 0006, paragraph 0032-0034, embodiment 2, and table 1 | 17, 22 |
| Y | CN 111900413 A (ZHUHAI COSMX BATTERY CO., LTD.) 06 November 2020 (2020-11-06)<br>description, paragraphs 0019 and 0065 | 17, 22 |
| A | CN 103384012 A (DONGGUAN AMPEREX TECHNOLOGY LTD.) 06 November 2013 (2013-11-06)<br>entire document | 1-26 |
| A | CN 116646530 A (ZHEJIANG CHENGYING NEW MATERIAL CO., LTD. et al.) 25 August 2023 (2023-08-25)<br>entire document | 1-26 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **30 October 2024** | **06 November 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**

International application No.
**PCT/CN2024/114578**

**C. DOCUMENTS CONSIDERED TO BE RELEVANT**

| Category* | Citation of document, with indication, where appropriate, of the relevant passages | Relevant to claim No. |
|---|---|---|
| A | CN 113270589 A (XIAMEN HITHIUM NEW ENERGY TECHNOLOGY CO., LTD.) 17 August 2021 (2021-08-17)<br>entire document | 1-26 |
| A | CN 115416381 A (GUANGZHOU FANGBANG ELECTRONICS CO., LTD. et al.) 02 December 2022 (2022-12-02)<br>entire document | 1-26 |
| A | WO 2015020338 A1 (AMOGREENTECH CO., LTD.) 12 February 2015 (2015-02-12)<br>entire document | 1-26 |

Form PCT/ISA/210 (second sheet) (July 2022)

**INTERNATIONAL SEARCH REPORT**
**Information on patent family members**

International application No.
**PCT/CN2024/114578**

| Patent document cited in search report | Publication date (day/month/year) | Patent family member(s) | Publication date (day/month/year) |
|---|---|---|---|
| CN 116895761 A | 17 October 2023 | None | |
| CN 111900413 A | 06 November 2020 | None | |
| CN 103384012 A | 06 November 2013 | None | |
| CN 116646530 A | 25 August 2023 | None | |
| CN 113270589 A | 17 August 2021 | None | |
| CN 115416381 A | 02 December 2022 | None | |
| WO 2015020338 A1 | 12 February 2015 | None | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202311606674